Europäisches Patentamt

European Patent Office

Office européen des brevets

(11) Publication number: **0 206 481**
**A2**

# (12) EUROPEAN PATENT APPLICATION

(21) Application number: 86303421.1

(51) Int. Cl.⁴: **H01L 23/52**

(22) Date of filing: 06.05.86

The title of the invention has been amended (Guidelines for Examination in the EPO, A-III, 7.3).

(30) Priority: 07.05.85 JP 95485/85

(43) Date of publication of application:
**30.12.86 Bulletin 86/52**

(84) Designated Contracting States:
**DE FR GB IT**

(71) Applicant: **HITACHI, LTD.**
**6, Kanda Surugadai 4-chome Chiyoda-ku**
**Tokyo 100(JP)**

(72) Inventor: **Koike, Atsuyoshi**
**Houyu Dormitory 21-11, Higashikoigakubo**
**2-chome**
**Kokubunji-shi Tokyo(JP)**
Inventor: **Meguro, Satoshi**
**2196-662, Hirai Hinode-machi**
**Nishitama-gun Tokyo(JP)**
Inventor: **Ikeda, Shuji**
**15-3, Midori-cho 5-chome**
**Koganei-shi Tokyo(JP)**
Inventor: **Takeda, Toshifumi**
**Seishin Dormitory 1503 Johsuihon-cho**
**Kodaira-shi Tokyo(JP)**

(74) Representative: **Calderbank, Thomas Roger et al**
**MEWBURN ELLIS & CO. 2/3 Cursitor Street**
**London EC4A 1BQ(GB)**

(54) Semiconductor device having a multi-layered wiring.

(57) A semiconductor device has sidewall parts (13) made of an insulating material on the sides of a lower metal wiring layer (12). The surface slope shape of the sidewall parts (13) is utilized in order to smooth out the step at the sides of the lower metal wiring layer (12). Thus it becomes possible to prevent breakages at the step in an upper metal wiring layer (15), formed on an insulating layer (14) covering the lower wiring layer (12) and the sidewall parts (13). It is also then possible to eliminate etching "remainder" and hillocks in the lower wiring layer - (12). Thus a multi-layered wiring structure having high reliability can be obtained.

FIG. 1

## SEMICONDUCTOR DEVICE AND METHOD OF PRODUCING SUCH A DEVICE

This invention relates generally to a semiconductor device and method of producing such a device. More particularly, the present invention relates to a semiconductor device involving multi-layered wiring.

In order to obtain a semiconductor device with a high integration (packing) density and a high operation speed it is becoming increasingly common to use a multilayered wiring structure to connect semiconductor elements to one another. The width of the wiring layer has been miniaturized with the miniaturization of the semiconductor elements. Therefore, the ratio of thickness to width of the wiring layer becomes significant and the steps at the sides of the wiring layer become more and more steep. In particular, the steps on both sides of a lower wiring layer become steep and coverage of an upper wiring layer to be formed thereon gets deteriorated and cut of the step is likely to occur or remainder of etching is left at the steps at the time of patterning of the upper wiring layer. Thus, the reliability of wiring drops.

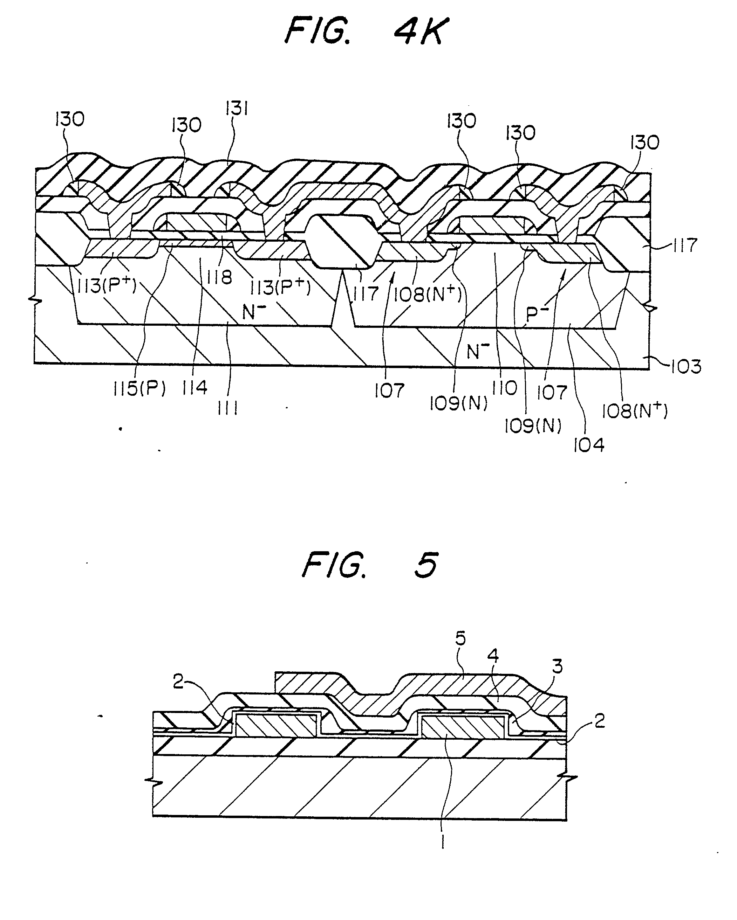

Attempts have herefore been made to make flat the wiring layer. For example, a structure shown in Fig. 5 of the accompanying drawings has been proposed. In this structure, after a thin silicon dioxide film 2 is formed on a lower aluminum (A$\ell$) wiring layer 1 by plasma CVD (Chemical Vapor Deposition), an SOG (Spin On Glass) film 3 is coated on the silicon dioxide film 2 and a PSG - (Phospho-Silicate Glass) film 4 is further formed thereon as an interlevel insulating film. According to this structure, the SOG film 3 stays at the side portions of the A$\ell$ wiring layer 1 due to its own viscosity when it is coated, and changes the skirts of the side portions of the A$\ell$ wiring layer 1 into a gentle slope. Therefore, the steep steps on both sides of the lower A$\ell$ wiring layer 1 can be eliminated and the cut of step of the upper A$\ell$ wiring layer 5 and etching remainder at the time of patterning can be prevented.

According to this structure, however, the SOG film 3 is likely to peel and swell so that the breakage and float of the upper A$\ell$ wiring layer 5 are likely to occur and the reliability drops as much. In addition, since high temperature treatment (about 450°C) is necessary for annealing the SOG film 3 and hence hillocks are likely to develop in the lower A$\ell$ wiring layer 1.

In connection with the method of making flat the multi-layered wirings, various structures including the structure shown in Fig. 5 are described in the literature "Semiconductor World" October, 1984, p. 116 -137, published by K.K. Press Journal.

It is therefore an object of the present invention provide a semiconductor device having high reliability.

It is another object of the present invention to provide a method of producing a semiconductor device which is easy to produce and can provide a wiring structure having high reliability.

It is still another object of the present invention to provide a semiconductor device and method of producing the same which can make flat a wiring layer without using an SOG film so that not only the cut of step in an upper wiring layer and etching remainder can be prevented, but also reliability can be improved and the occurrence of hillock in a lower wiring layer can be prevented.

These and other objects and novel features of the present invention will become more apparent from the following detailed description when taken in conjunction with the accompanying drawings.

Among the inventions disclosed herein, the following is a typical example.

Sidewalls made of an insulating material are formed on both sides of a lower metal wiring layer, and the steps of the lower metal wiring layer are mitigated by utilizing the surface slope shape of these sidewalls. In consequence, the cut of steps in an upper metal wiring layer and etching remainder can be prevented, hillock in the lower metal wiring layer can be prevented, too, and a highly reliable multi-layered wiring structure can be obtained.

In the drawings:

Fig. 1 is a sectional view of a semiconductor device in accordance with one embodiment of the present invention;

Figs. 2A and 2B are sectional views showing the semiconductor device shown in Fig. 1, particularly the formation process of its sidewalls;

Fig. 3 is a sectional view showing an application example of the present invention to a CMOS - (Complementary Metal Oxide Semiconductor) type semiconductor integrated circuit device (IC);

Figs. 4A to 4K are sectional views showing the production steps of CMOS IC shown in Fig. 3; and

Fig. 5 is a sectional view of a semiconductor device having a conventional structure.

Embodiment I

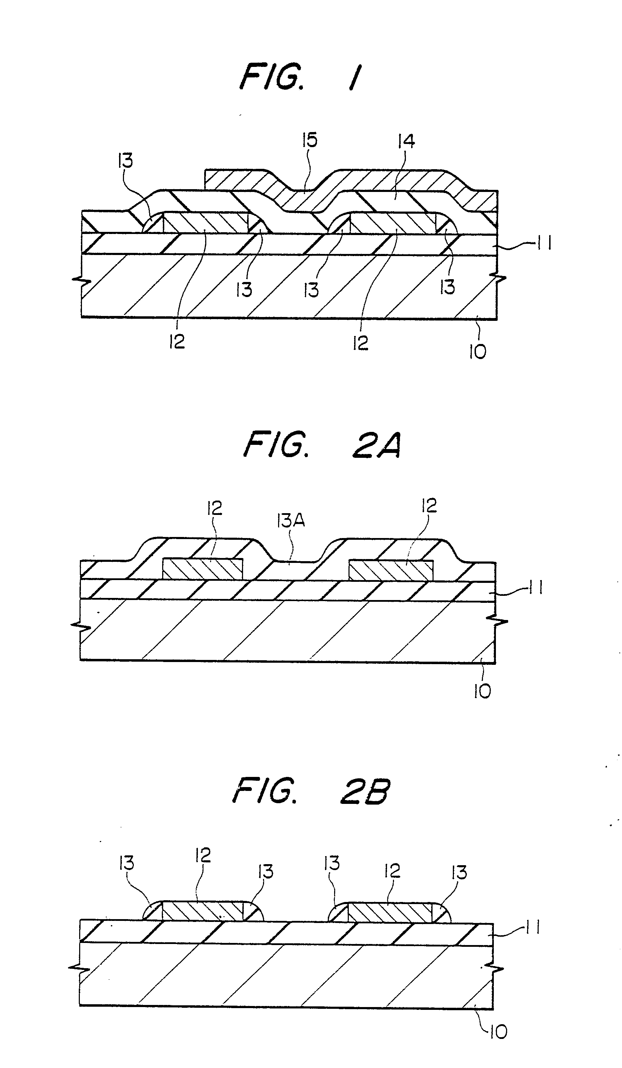

Fig. 1 illustrates a semiconductor device in accordance with one embodiment of the present invention. The drawing shows particularly an application example of the present invention to a multi-layered wiring structure using aluminum (A$\ell$) multi-layered wiring layers.

In the drawing, reference numeral 11 denotes an insulating film which is formed on a semiconductor substrate 11 such as a silicon substrate and is made of PSG. A first Aℓ wiring layer 12 as a lower metal wiring layer is formed on the substrate in a predetermined pattern. Sidewalls 13, 13 made of silicon nitride are integrally formed on both sides of the first Aℓ wiring layer 12 in such a manner as to define slopes on both sides of the first Aℓ wiring layer 12. As will be described elsewhere, these sidewalls 13, 13 are formed by deposition by CVD (Chemical Vapor Deposition) and etching by high anisotropic etching. A PSG (Phospho-Silicate Glass) film 14 is then formed on the first Aℓ wiring layer 12, and a second Aℓ wiring layer 15 as an upper metal wiring layer is pattern-formed on the PSG film 14.

Next, the method of producing the semiconductor device of this embodiment will be described with primary reference to be formation method of the sidewalls 13, 13.

After the first Aℓ wiring layer 12 is formed as depicted in Fig. 2A, silicon nitride is deposited on the entire surface by plasms CVD at normal or low temperature in order to forma silicon nitride film 13A which has substantially the same thickness as the first Aℓ wiring layer 12. Next, the entire surface is etched by an etching method having high anisotropy such as RIE (Reactive Ion Etching), whereby the silicon nitride film 13A is etched and removed from the portions of the first Aℓ wiring layer other than both side portions of the first Aℓ wiring layer 12. In this manner, the silicon nitride film 13A remains only on both sides of the first Aℓ wiring layer 12, thereby forming the sidewalls 13, 13. These sidewalls 13, 13 have a curved surface having a gentle slope and mitigate substantially the steps on both sides of the first Aℓ wiring layer 12. At this time, the etching selection ratio of the PSG film as an insulating film to silicon nitride to be etched is great in this embodiment. (In other words, the silicon nitride film is etched but the PSG film is hardly etched.) Therefore, the silicon nitride film 13A can be etched effectively without drastically etching the insulating film 11.

According to the multi-layered wiring structure described above, therefore, the inclination on both sides of the first Aℓ wiring layer 12 is mitigated by the sidewalls 13, 13 so that a steep step can be avoided, and the surface step of the PSG film 14 formed on the sidewalls can be made smooth and gentle. Therefore, when the second Aℓ wiring layer 15 is formed, its coverage on both sides of the first Aℓ wiring layer 12 can be improved so that the cut of step does not occur and any remainder of etching is not left, either, at the time of patterning of the second Aℓ wiring layer 15.

Since this structure does not use the SOG film, high temperature heat treatment for annealing is not necessary in order to form the sidewalls 13, 13 and the PSG film 14, and the heat treating temperature at the time of CVD can be kept below about 200°C. For these reasons, any hillocks do not develop on the surface of the first Aℓ wiring layer 12. Additionally, since the SOG film is not used, peel or expansion of the interlevel insulating film does not occur and float or breakage of the second Aℓ wiring layer 15 can of course be prevented.

Embodiment 2

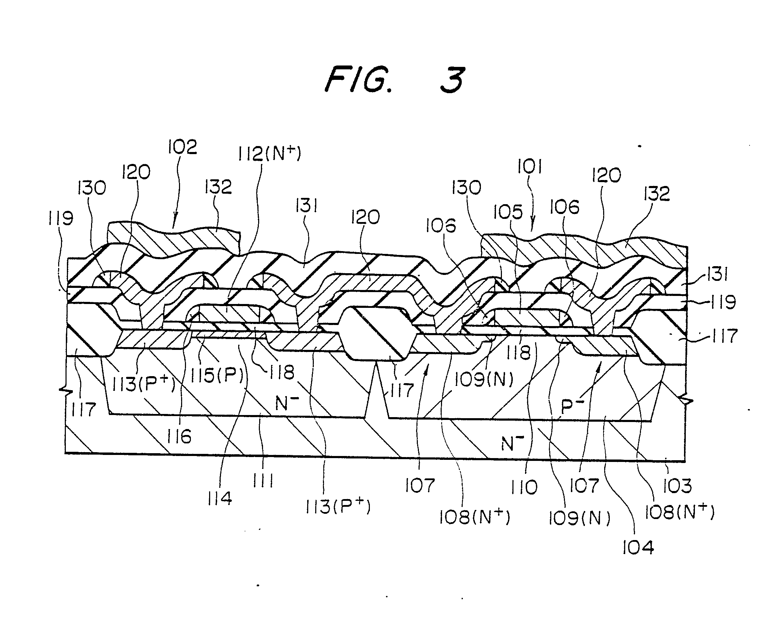

Fig. 3 illustrates an application example of the present invention to CMOS IC. Particularly, in a CMOS IC consisting of an N channel MOSFET - (Metal Insulator Semiconductor Field Effect Transistor) 101 and a P-channel MOSFET 102, this embodiment illustrates an example in which an LDD (Lightly Doped Drain) structure is used for the N-channel MOSFET 101 and a structure for reducing a short channel effect and improving the breakdown voltage of a drain junction is used for the P-channel MOSFET 102.

The N-channel MOSFET 101 is formed in a $P^-$-type well (semiconductor region) 104 in a semiconductor substrate 103 made of an $N^-$-type single crystal silicon.

The MOSFET 101 comprises a gate electrode 105 consisting of a plycrystalline silicon, a gate insulating film 118 consistinf of a silicon dioxide film and a source-drain region 107 of an LDD structure formed by utilizing sidewall spaces 106, 106 formed on both sides of the gate electrode 105.

The source-drain region 107 of the LDD structure in turn comprises an $N^+$-type semiconductor layer 108 having a high impurity concentration and formed in the spaced-apart (offset) relation with the gate electrode 105 and an N-type semiconductor layer 109 of a low impurity concentration that continues the $N^+$-type semiconductor layer 108 and extends up to the portion below the gate electrode 105. In the case of this embodiment, the $N^+$-type semiconductor layer 108 is formed by use of arsenic (As) while the N-type semiconductor layer 109 is formed by use of phosphorus (P). Boron (B) is introduced into the portion below the gate electrode 105, that is, into the surface of the channel 10, by ion implantation in order to adjust a threshold voltage. (Boron is not shown in the drawing.)

On the other hand, the P-channel MOSFET 102 is formed in an $N^-$-type well (semiconductor region) 111 in the substrate 103. MOSFET 102 comprises a gate electrode 112 of polycrystalline silicon into which an N-type impurity is doped in a high concentration, a gate insulating film 18 and a P+-type source-drain region 113. The source-drain region 113 is formed in the spaced-apart (offset) relation with the gate electrode 112. Namely, the end portion of the region 113 does not exist below the gate electrode 112.

The source-drain region 113 is connected to a channel layer 115 which is formed below the gate electrode 112, that is, on the surface of the channel 114, and is made of a P-type semiconductor region. This channel layer 115 is formed by doping boron in a relatively low concentration simultaneously with the ion implanation for adjusting the threshold voltage of the N-channel MOSFET described above. The source-drain region 113 is formed by doping the same impurity, that is, boron, in a high impurity concentration. The region 115 has a lower impurity concentration a smaller junction depth than the region 113. Reference numeral 116 denotes sidewall spacers that are formed on both sides of the gate electrode 112.

In the drawing, reference numeral 117 denotes a field insulating film consisting of silicon dioxide ($SiO_2$) film, and reference numeral 119 denotes an interlevel insulating film made of PSG - (PhosphoSilicate Glass) film. Reference numeral 120 denotes an aluminum (A$\ell$) wiring.

In the N-channel MOSFET 101 in the CMOS device having the construction described above, mitigation of the electric field by the semiconductor layer of a low impurity concentration and low resistance by the semiconductor layer 108 of a high impurity concentration can be accomplished. Therefore, the breakdown voltage of the drain junction (the P-N junction between the drain region and the well) can be improved and the short channel effect can be reduced.

In the P-channel MOSFET 102 of the CMOS device, on the other hand, the P-type channel layer 115 and the P+-type source-drain region 113 having the same conductivity type and the offset structure are formed continuously and integrally with each other.

A part of the channel layer 115 exhibits the same operation as the region 109 in the N-channel MOSFET and functions as a region that mitigates the electric field in the vicinity of the junction formed by the drain region 113. Namely, this structure can be regarded as a kind of LDD structures. For this reason, the breakdown voltage of the drain junction can be improved and the occurrence of hot carriers can be restricted.

Since the channel layer 115 exists, it is not necessary to diffuse the high impurity source-drain region 113 until its end reaches the portion below the gate electrode 112. Therefore, the short channel effect can be reduced and the miller capacity can be reduced, too.

Since the source-drain region 113 need not be formed in such a manner as to reach the portion below the gate electrode 112. it can have a high impurity concentration and its resistance can be reduced.

The channel of the P-channel MOSFET 102 is a so-called "buried channel" which is primarily formed at the junction between the channel layer 115 and the well 111. In this case, the MOSFET 102 is of the enhancement type but not of the depletion type due to the difference $\phi_{MS}$ of the work functions between the gate electrode 112 and the channel 114. For this reason, an N-type impurity such as P is introduced into the gate electrode 112 in a high concentration such as up to twenty-odds ohms/square, while the N-type channel layer 115 is formed in an extremely limited depth. Since the channel is the buried channel, high mobility can be obtained for the hot carriers. Since the distance is great between the gate electrode 112 and the channel, the hot carriers are hardly affected by the electric field of the gate electrode 112, and are hence not injected into the gate insulating film 118. Furthermore, since the drain junction does not exist below the gate electrode 112, the electric field can be mitigated in this respect, too.

MOSFET 102 is of the buried channel type and moreover, has the source-drain region of the offset structure with respect to the gate electrode. Therefore, the effects described above can be easily obtained.

For the reasons described above, not only the N-channel MOSFET 101 but also the P-channel MOSFET 102 can be formed in the short channel structure, or in other words, scale-down - (miniaturization) of these transistors can be accomplished, and the integration (packing) density of the P-channel MOSFET and CMOS containing the P-channel MOSFETs can be improved.

Incidentally, a material having the equal or approximate work function to that of the polycrystalline silicon into which an N-type impurity is doped in a high concentration can be used as the material for the gate electrode 112.

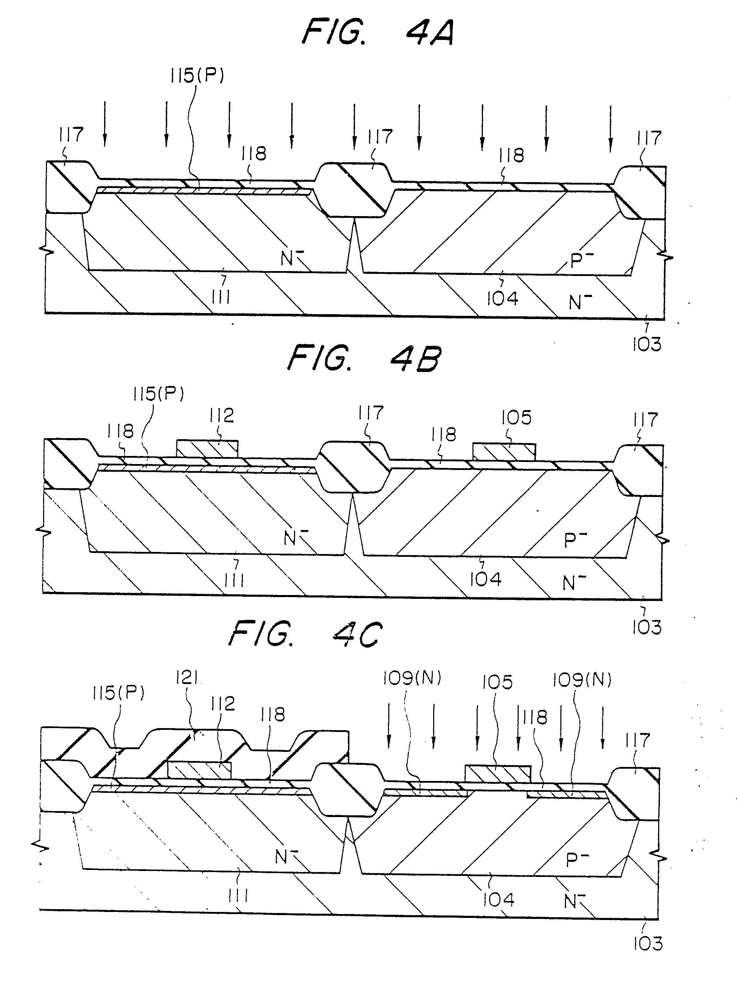

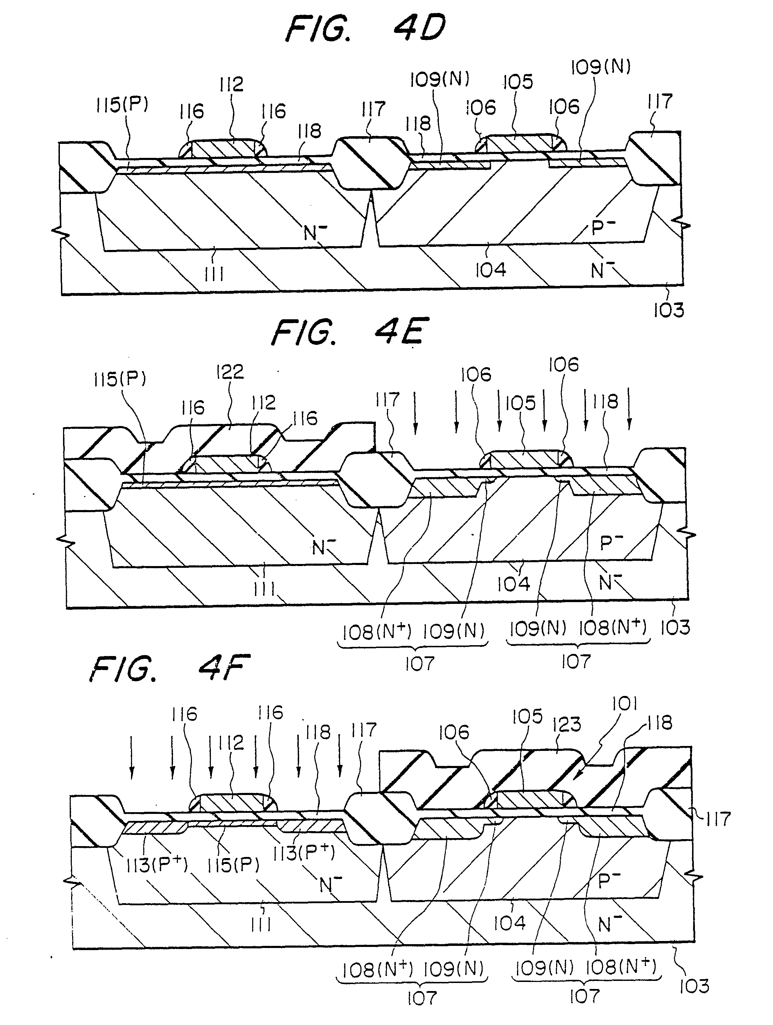

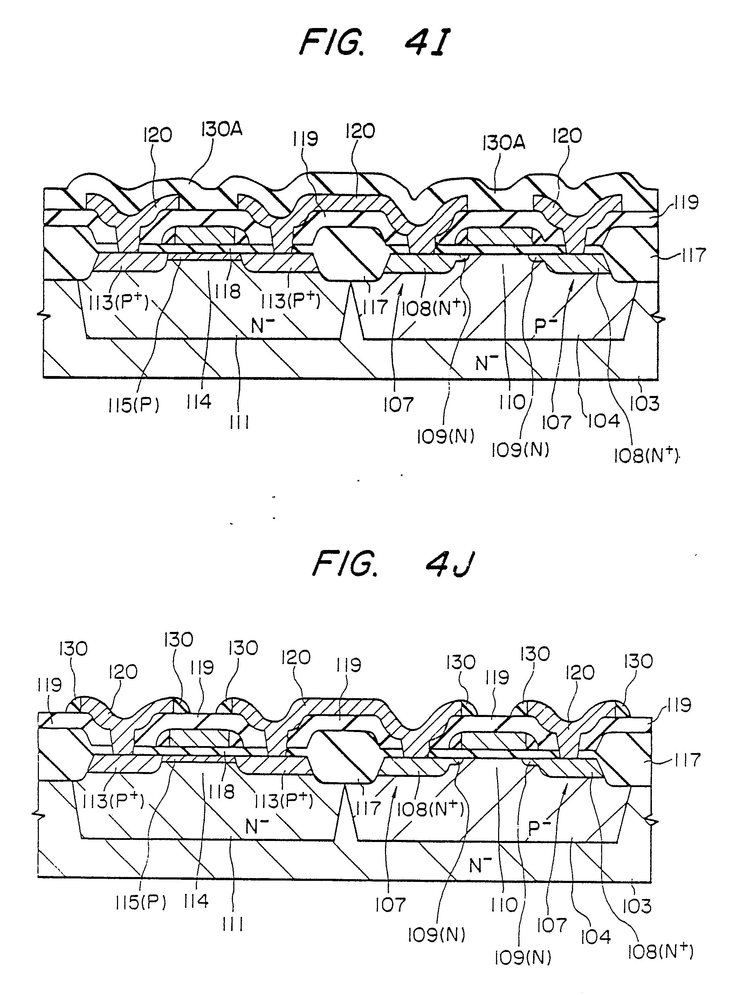

Next, an example of the production method of CMOS device shown in Fig. 3 will be described with reference to Figs. 4A to 4K.

First of all, a P−-type well 104 having a concentration of $1 \times 10^{15}$ atoms.cm$^{-3}$ and an N−-type well having a concentration of $2 \times 10^{16}$ atoms.cm$^{-3}$ are formed in an N−-type silicon substrate 103 having an impurity concentration of $4 \times 10^{14}$ atoms.cm$^{-3}$ as shown in Fig. 4A. Next, a field insulating film 117 consisting of $SiO^2$ is formed by the local thermal oxidation of the main surface of the substrate 103, and a gate insulating film 118 is formed by the thermal oxidation of the main surface of the substrate 103 at the portion where the field insulating film 117 does not exist (active region). Under this state boron (B) is ion-implanted to the entire surface in order to adjust the threshold voltage of the N-channel MOSFET 101. On the other hand, this ion implantation forms a P-type channel layer 115 having a concentration of $5\times10^{16}$ atoms.$cm^{-3}$ (dose: $1\times10^{12}$ atoms.$cm^{-2}$) on the surface of the N-type well 111.

In this embodiment, the single ion implantation step controls the threshold voltage and forms the buried channel. Therefore, when the well 111 is formed, its impurity concentration is determined independently of the impurity concentration of the substrate 103. This makes it easy to set the dose of ion implantation.

Next, the polycrystalline silicon formed on the entire surface of the substrate by CVD is selectively etched to form the gate electrodes 105, 112 on the gate insulating film 118 as shown in Fig. 2B.

One of the regions (N-type well 111) is covered with a photoresist film 121 as shown in Fig. 4C. Under this state an N-type impurity such as phosphorus (P) is ion-implanted using the gate electrode 5 as the mask to form a semiconductor layer 109 having a low impurity concentration of $1\times10^{18}$ atoms.cm (dose: $1\times10^{13}$ atoms.cm $^{-2}$) in the P-type well 104.

After the photoresist film 121 is removed, a silicon dioxide ($SiO_2$) film is deposited on the entire upper surface of the substrate by CVD and is then etched anisotropically by RIE (reactive ion etching). In this manner, sidewall spacers 106, 116 are formed on both sides of each of the gate electrodes 105, 112.

Next, the N-type well 111 is again masked by the photoresist film 122 as shown in Fig. 4E. Under this state an N-type impurity such as arsenic (As) is ion-implanted using the gate electrode 105 and the sidewall spacers 106 as the mask, thereby forming a semiconductor layer 108 having a high impurity concentration of $1\times10^{21}$ atoms.cm $^{-3}$ (dose: $1\times10^{16}$ atoms $cm^{-2}$). As a result, the low impurity concentration layer 109 and the high impurity concentration layer 108 together constitute the source-drain region 107 of the LDD structure. In other words, an N-channel MOSFET of the LDD structure is formed on the P-type well 104.

Next, the N-channel MOSFET 101 thus completed is masked by the photoresist film 123 as shown in Fig. 4F. Under this state a P-type impurity such as boron (B) is ion-implanted using the gate electrode 112 and the sidewall spacers 116 as the mask. The concentration is $10^{20}$ atoms.$cm^{-3}$ - (dose: $2\times10^{15}$ atoms. $cm^{-2}$) and is relatively high, and diffusion is effected until the end portion of the region 113 reaches the intermediate position below the sidewall spacer 116.

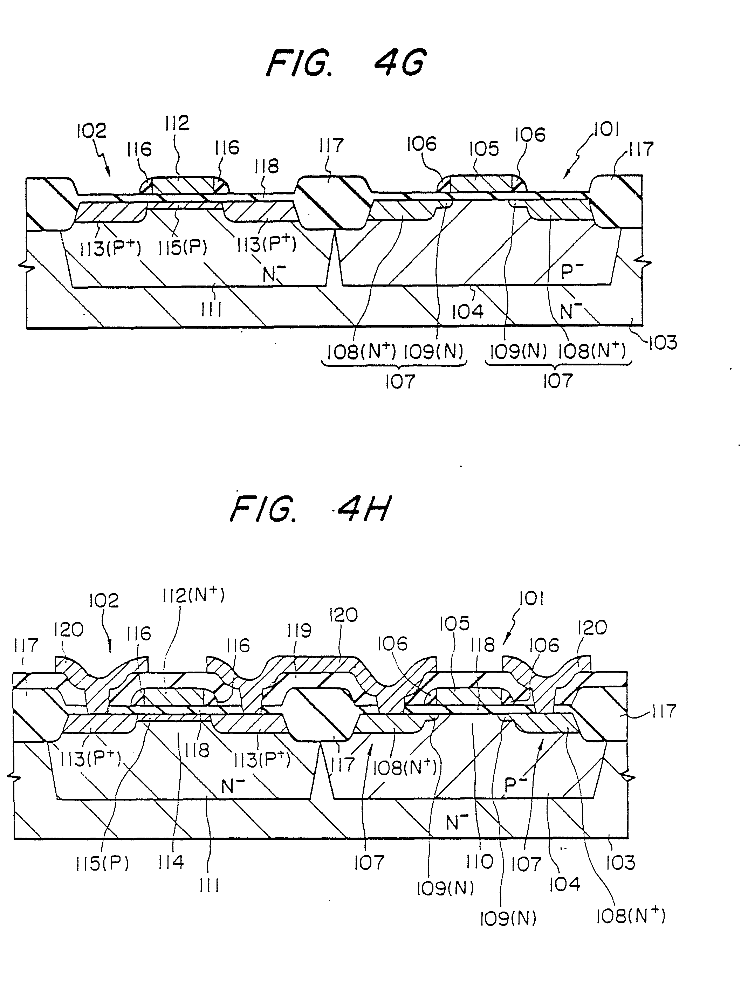

There is thus formed the source-drain region 113 which is isolated from the gate electrode 112 but continues the channel layer 115 as shown in Fig. 4G, and a P-channel MOSFET 102 is completed.

Next, a PSG film 119 as an interlevel insulating film 119 is formed as shown in Fig. 4H. After a contact hole is formed, an aluminum film is deposited by spattering and is patterned to form an aluminum wiring 120.

After the first aluminum wiring 120 is thus formed as shown in Fig. 4I, silicon nitride is deposited on the entire surface by plasma CVD at normal or low temperature to form a silicon nitride film 130A whose thickness is substantially equal to that of the first Al wiring layer 120. Next, the entire surface is etched by an etching process having high anisotropy such as RIE (reactive ion etching), whereby the silicon nitride film 130A is etched and removed at the portions other than both sides of the first Al wiring layer 120, and remains only on both sides of the first Al wiring layer 120, thereby forming the sidewalls 130. Each sidewall 130 has a curved surface of a gentle slope and substantially mitigates the steps on both sides of the first Al wiring layer 120. In this embodiment, the etching selection ratio of PSG as the insulating film to silicon nitride to be etched is great. (In other words, though the silicon nitride film is etched, the PSG film is hardly etched). Therefore, the silicon nitride film 130A can be etched effectively without drastically etching the insulating film 119.

According to the multi-layered wiring structure having the construction described above, the inclination on both sides of the first Al wiring layer 120 is mitigated by the sidewalls 130 so that a steep step can be avoided and the surface step of the PSG film 131 to be formed thereon can be made smooth and almost flat as shown in Fig. 4K. Next, when a second Al wiring layer 132 is to be formed, too, coverage can be improved on both sides of the first Al wiring layer 120 and cut of the step does not occur, and the non-etched portion is not left at the time of patterning of the second Al wiring layer 132.

Since this construction does not use the SOG film, high temperature annealing treatment is not necessary when forming the sidewalls 130 and the PSG film 131. Since heat-treatment is restricted to around 200°C at the time of CVD, any hillock does not occur on the surface of the first Al wiring layer 120. Since no SOG film is used, peel or swell of the film does not occur, either, and hence the float and breakage of the second Al wiring layer 132 can of course be prevented.

The effects that may be achievable will be discussed below.

The sidewalls of the insulating material are formed on both sides of the lower metal wiring layer so as to mitigate the inclination and to make flat the upper surface of the sidewalls. Therefore, coverage of the upper metal wiring layer to be formed on the insulating film can be improved and cut of the step can be prevented. At the same time, remainder of etching can be prevented at the time of forming the upper metal wiring layer, and reliability of the upper metal wiring layer can be improved.

Since no SOG film is used, high temperature treatment at the time of annealing is not necessary and hence any hillock does not occur on the metal wiring layers, particularly on the lower aluminum wiring layer, and its reliability can be improved.

Since no SOG film is used as the interlevel insulating film, peel or expansion of the film does not occur and particularly, the float and breakage of the upper metal wiring layer can be prevented.

Since the sidewalls can be formed by the film deposition step by CVD and the anisotropic etching step, they can be formed by an extremely small number of steps and the production process of the multilayered wiring structure can be simplified.

Although the present invention has thus been described in its preferred forms, the invention is not particularly limited thereto but can of course be practised in various manners without departing from the gist and scope thereof.

For example, silicon dioxide ($SiO_2$) by plasma CVD by using suitable conditions for the etching gas and PSG can be used for the sidewalls. If a large etching selection ratio can be obtained with respect to the base layer, other materials can also be used. Furthermore, materials other than aluminum ($Al$) can be used for the upper and lower metal wiring layers.

Although the invention has been described with primary reference to the semiconductor device having the two-layered wiring structure as the background and field of the present invention, the present invention is not particularly limited thereto but can also be applied to semiconductor devices having a three-or more layered wiring layer.

Furthermore, the production process of the CMOS IC described above is easier than the conventional processes. For, the channel layer 115 can be formed at the step where the impurity for adjusting the threshold voltage of the MOSFET having the opposite conductivity type is introduced. The sidewalls can be formed at the same process step as that of the LDD structure. Unlike the substrate 103, the channel layer is disposed in the well 111 having a higher impurity concentration than the substrate so that the introduction step of an impurity having an opposite conductivity type to the channel layer for forming the buried channel is not particularly necessary. The characteristics of the MOS transistor 102 can be determined by controlling the concentration of the well 111.

Besides the effects described above, the present invention may also provide the following effects.

The source-drain region of MOSFET has the offset structure with respect to the gate electrode and continues the channel layer having the same conductivity type. Therefore, part of the channel layer can function as a field mitigation region and the resistance can be reduced by the source-drain region having a high impurity concentration.. As a result, MOSFET having a high breakdown voltage, a high operation speed and a reduced short channel effect can be completed.

Even when the channel layer and the sourcedrain region are constituted by the same impurity, the breakdown voltage, the high operation speed and the reduction of the short channel effect can be accomplished in substantially the same way as the LDD structure. Therefore, miniaturization of the P-channel MOS transistor and eventually, a semiconductor device containing the P-channel MOS transistor, can be accomplished.

Part of the production step of CMOS IC containing the N-channel MOSFET having the LDD structure is utilized as such in order to form CMOS IC containing the transistor having the structure of the present invention, and the production process becomes extremely easy.

The structure of the present invention can be applied, for example, to the N-channel MOSFET formed on the P⁻-type substrate (or the well). An N-type source-drain region having a high impurity concentration is formed by self-alignment utilizing the N-type channel layer having a low impurity concentration, the gate electrode and the sidewall spacers. As or P may be used as the impurity. In order to obtain an enhancement type N-channel MOSFET having a buried channel, it is important that the gate electrode be composed of polycrystalline silicon into which a P-type impurity - (such as B) is introduced in a high concentration, or be composed of a material having the equal or approximate work function to that of polycrystalline silicon.

Ion implantation shown in Fig. 4A may be divided into two steps. In other words, the ion implantation for forming the channel region 115 of one MOSFET may be effected separately from the ion implantation for adjusting the threshold voltage of the other MOSFET. In this case, the dose of the impurity to be doped may be decided to an optimal value independently of each other.

The well region 111 having the same conductivity type as that of the substrate 103 can be omitted. Particularly when the ion implantation shown in Fig. 4A is divided into the two steps as described above, the well region 111 may be deleted.

The channel region 115 may be formed in the spaced-apart relation from the main surface of the semiconductor substrate so long as the depletion layer formed on the main surface of the semiconductor substrate by the work function of the gate electrode is under such a state where it covers the channel region 115. In this case, MOSFET becomes of an enhancement type.

When the source-drain region consisting of the semiconductor region having a high impurity concentration is formed in the spaced-apart relation from the gate electrode, it may be formed without using the sidewall spacers, such as ion implantation using a mask consisting of a photoresist film.

The gate electrode for forming the enhancement type MOSFET having the buried channel may have a polycide structure. In other words, it is possible to use a gate electrode consisting of a polycrystalline silicon layer into which B or P is doped and a silicide layer of a refractory metal - (e.g. Mo, W, Ta, Ti) that is formed on the polycrystalline silicon layer. Furthermore, the gate electrode may have a structure in which the layer of the refractory metal described above is formed on the polycrystalline silicon layer.

When the sidewall is formed by the silicon dioxide $(SiO_2)$ film which is in turn formed by CVD, hot carrier trap can be reduced by effecting heat-treatment in an $O_2$ atmosphere after the formation of the sidewall spacers to improve the film properties of the sidewall spacers.

The description given above primarily deals with the application of the present invention to the CMOS device as the background and field of utilization of the present invention, but the present invention is not particularly limited to the embodiments given already. For example, the invention can also be applied to ICs consisting solely of P-channel MOSFETs or N-channel MOSFETs.

When the present invention is applied to CMOS IC, the N-channel MOSFET need not have the LDD structure. Furthermore, the present invention may be applied to the N-channel MOSFETs or both the N-and P-channel MOSFETs in CMOS IC.

## Claims

1. A semiconductor device having a lower layer wiring film (12), an upper layer wiring film (15), and an insulating film (14) between the upper and lower layer wiring films (12,15);

characterised in that:

sidewell parts (13) are provided on the sides of the lower layer wiring film (12,15).

2. A semiconductor device according to claim 1 wherein the sidewall parts (13) are of an insulating material.

3. A semiconductor device according to claim 1 or claim 2, wherein the sidewall parts (13) are of silicon nitride.

4. A semiconductor device according to any one of claims 1 to 3 wherein the lower layer wiring film (12) is of a wiring material having aluminum as its principal component.

5. A semiconductor device according to any one of the preceding claims, having a substrate - (10) with a semiconductor element therein, the lower layer wiring film being connected electrically to the semiconductor element and being formed by etching a material different from the material of the substrate.

6. A semiconductor device according to claim 5, wherein the semiconductor element includes at least one MISFET.

7. A semiconductor device according to claim 5 or claim 6, wherein the semiconductor element includes at least a CMIS IC.

8. A semiconductor device according to any one of claims 5 to 7 wherein the semiconductor element includes at least one bipolar transistor.

9. A method of producing a semiconductor device, including:

forming a first wiring film (12) on a semiconductor substrate (10);

forming an interlevel insulating film (14) covering the first wiring film (12);

forming a contact hole in the insulating film (14); and

forming a second wiring film (15) on the insulating film (14);

characterised in that:

sidewall parts (13) are formed on the sides of the first wiring film (12), and the insulating film (14) covers both the first wiring film (12) and the sidewall parts (13).

10. A method according to claim 9, wherein the first wiring film (12) is of a material having aluminum as its principal component.

11. A method according to claim 9 or claim 10, wherein the sidewall parts (13) are of an insulating material.

12. A method according to any one of claims 9 to 11, wherein the sidewall parts (13) are formed by forming a further film of a material different from the material of the first wiring film (12) so as to cover the first wiring film (12), and then etching the further film to define the sidewall parts (13).

13. A method according to any one of claims 9 to 12, wherein the sidewall parts (13) are formed by forming a silicon nitride film by a chemical vapor deposition (CVD) method and selectively etching and removing the silicon nitride film by a reactive ion etching (RIE) method having high anisotropy.

14. A method according to any one of claims 9 to 13 wherein the interlevel insulating film is a phosphosilicate glass (PSG) film.

15. A method according to any one of claims 9 to 14, wherein a semiconductor element is formed in the substrate.

16. A method according to claim 15, wherein the step of forming the semiconductor element includes forming a MIS IC having a gate electrode on a silicon substrate.

17. A method according to claim 15 wherein the step of forming the semiconductor element includes forming a MIS IC having a gate electrode and an LDD structure on a silicon substrate.

18. A semiconductor device formed by a method according to any one of claims 9 to 17.

FIG. 1

FIG. 2A

FIG. 2B

# FIG. 3

# FIG. 4A

# FIG. 4B

# FIG. 4C

## FIG. 4D

## FIG. 4E

## FIG. 4F

# FIG. 4G

102
116  112  116  118  117  106  105  106  101  117

113(P⁺)  115(P)  113(P⁺)

N⁻

111

P⁻

N⁻

104

103

108(N⁺) 109(N)  109(N) 108(N⁺)

107  107

# FIG. 4H

117  120  102  116  112(N⁺)  116  119  120  106  105  118  106  120  101

113(P⁺)  118  113(P⁺)  117  108(N⁺)

N⁻  P⁻  117

115(P)  114  111  107  N⁻  110  107  103

109(N)  109(N)  104

108(N⁺)

## FIG. 4I

120  130A  119  120  130A  120  119  117
113(P⁺)  118  113(P⁺)  117 108(N⁺)  P⁻  N⁻  N⁻
115(P)  114  111  107  110  107  104  103  109(N)  109(N)  108(N⁺)

## FIG. 4J

130  130  130  120  119  130  130  120  130
119  120  119  119  119  117
113(P⁺)  118  113(P⁺)  117 108(N⁺)  P⁻  N⁻  N⁻
115(P)  114  111  107  110  107  104  103  109(N)  109(N)  108(N⁺)

# FIG. 4K

130 130 131 130 130 130

113(P⁺) 118 113(P⁺) 117 108(N⁺) 117

N⁻ P⁻

N⁻ 103

115(P) 114 107 110 107 108(N⁺)

111 109(N) 109(N) 104

# FIG. 5

5 4 3

2 2

1